# EUROPEAN PATENT APPLICATION

(11) **EP 4 607 798 A1**
(43) Date of publication of application: **27.08.2025**
(21) Application number: 25158564.2
(22) Date of filing: 18.02.2025
(51) Int. Cl.: H03K 17/18, H01H 39/00, H02H 3/08, H02H 7/10, G01R 31/327, G05B 9/03, H02H 7/12, H02H 7/20

(54) **CIRCUIT BREAKING APPARATUS AND PHOTOVOLTAIC POWER GENERATION SYSTEM**

(30) Priority: 21.02.2024 CN 202410194702
(71) Applicant: Huawei Digital Power Technologies Co., Ltd., Shenzhen, Guangdong 518043 (CN)
(72) Inventor: HU, Xing, Shenzhen 518043 (CN); LI, Wuying, Shenzhen 518043 (CN); TANG, Yunyu, Shenzhen 518043 (CN); ZHAN, Jinxiang, Shenzhen 518043 (CN); SHI, Lei, Shenzhen 518043 (CN); YU, Xiang, Shenzhen 518043 (CN)
(74) Representative: Isarpatent

(57) **Abstract**

This application discloses a circuit breaking apparatus and a photovoltaic power generation system, and relates to the photovoltaic energy storage field. When it is detected that a current on a circuit between two power devices connected in series to the circuit breaking apparatus is greater than a preset threshold, in this application, both two switch transistors in a drive circuit of the circuit breaking apparatus are controlled to be turned on. In this case, a large current is input to a breaking switch circuit of the circuit breaking apparatus to control the breaking switch circuit to break the circuit, so that the circuit breaking apparatus cuts off a fault current, to prevent fault spreading and ensure that the circuit is not damaged. In addition, because the circuit breaking apparatus is a "suicide" protection circuit, the drive circuit uses a design of the two switch transistors, and a direct current power supply inputs the large current to the breaking switch circuit only when both the two switch transistors are turned on, and the large current cannot be supplied when any one of the switch transistors is turned on. This helps avoid mistakenly triggering generation of the large current, and can ensure a trusted action of the drive circuit.

## Description

### TECHNICAL FIELD

This application relates to the field of photovoltaic energy storage, and in particular, to a circuit breaking apparatus and a photovoltaic power generation system.

### BACKGROUND

Security is the most concerned topic in a photovoltaic energy storage system. In the photovoltaic energy storage system, a converter/inverter usually needs to invert a direct current into an alternating current.

A power switch device in the converter/inverter is a circuit that is prone to a fault (for example, a short circuit or overload). When the power switch device is faulty, a short-circuit path for short-circuiting a battery may be formed. As a result, a power component on a battery side is damaged, and a fault of the photovoltaic energy storage system is spread, reducing security of the photovoltaic energy storage system. Therefore, to prevent fault spreading and ensure security of the photovoltaic energy storage system, a switch device with a fault current breaking function needs to be connected in series to the photovoltaic energy storage system.

### SUMMARY

According to a first aspect, this application provides a circuit breaking apparatus, including a breaking switch circuit and a drive circuit. The breaking switch circuit is connected in series between two power devices. The drive circuit includes a direct current power supply, a first switch transistor, a second switch transistor, a first resistor, a second resistor, and a controller. A first terminal of the first switch transistor is connected to a positive electrode of the direct current power supply through the first resistor, a second terminal of the first switch transistor is connected to a first terminal of a drive port of the breaking switch circuit, and a second terminal of the drive port of the breaking switch circuit is connected to a negative electrode of the direct current power supply. A first terminal of the second switch transistor is connected to the positive electrode of the direct current power supply, and a second terminal of the second switch transistor is connected to the negative electrode of the direct current power supply through the second resistor. The first terminal of the first switch transistor is connected to the second terminal of the second switch transistor. The controller is configured to: when a current on the circuit between the two power devices is greater than a preset threshold, control both the first switch transistor and the second switch transistor to be turned on. The breaking switch circuit is configured to break the circuit between the two power devices when both the first switch transistor and the second switch transistor are turned on.

It can be learned that when the current on the circuit between the two power devices is greater than the preset threshold, it indicates that a fault current occurs on the circuit. To prevent fault spreading and ensure that the circuit is not damaged, in this application, when it is detected that the fault current occurs on the circuit, the controller controls both the two switch transistors in the drive circuit to be turned on. In this case, the direct current power supply inputs a large current to the breaking switch circuit to control the breaking switch circuit to cut off the circuit, so that the circuit breaking apparatus cuts off the fault current.

In addition, because the breaking switch circuit breaks the circuit by damaging an interior component, the circuit breaking apparatus may be considered as a "suicide" protection circuit. In this way, in this application, generation of the large current needs to be not mistakenly triggered while a trusted action of the drive circuit is ensured. In this case, the drive circuit uses a design of the two switch transistors, and the direct current power supply inputs the large current to the breaking switch circuit only when both the two switch transistors are turned on, and the large current cannot be supplied to the breaking switch circuit when either of the switch transistors is turned on. This helps avoid mistakenly triggering generation of the large current, and can ensure the trusted action of the drive circuit.

In some possible examples, the controller is further configured to: when the first switch transistor is turned off, the second switch transistor is turned off, and a voltage between two terminals of the second resistor falls within a first preset range, output a signal indicating that the drive circuit is in a normal link state.

In this way, when the first switch transistor is turned off, the second switch transistor is turned off, and the voltage between the two terminals of the second resistor falls within the first preset range, it indicates that a link "First resistor->Second resistor" is normal, and both the first switch transistor and the second switch transistor are in a reliable off state, and no fault occurs. This indicates that the drive circuit is in the normal link state. The first preset range is determined based on data from a plurality of experiments.

In some possible examples, the controller is further configured to: when the first switch transistor is turned on, the second switch transistor is turned off, a voltage between the two terminals of the drive port of the breaking switch circuit falls within a second preset range, and a voltage between two terminals of the second resistor falls within a third preset range, output a signal indicating that the drive circuit is in a normal link state.

In this way, when the first switch transistor is turned on, the second switch transistor is turned off, and the voltage between the two terminals of the drive port of the breaking switch circuit falls within the second preset range, and the voltage between the two terminals of the second resistor falls within the third preset range, it indicates that a link "First resistor->First switch transistor->Breaking switch circuit" is normal, a link "First resistor->Second resistor" is normal, the first switch transistor is in a reliable on state, and the second switch transistor is in a reliable off state. This indicates that the drive circuit is in the normal link state. The second preset range and the third preset range are determined based on data from a plurality of experiments.

In some possible examples, the controller is further configured to: when the first switch transistor is turned off, the second switch transistor is turned on, and a voltage between two terminals of the second resistor falls within a fourth preset range, output a signal indicating that the drive circuit is in a normal link state.

In this way, when the first switch transistor is turned off, the second switch transistor is turned on, and the voltage between the two terminals of the second resistor falls within the fourth preset range, it indicates that a link "Second switch transistor>Second resistor" is normal, the first switch transistor is in a reliable off state, and the second switch transistor is in a reliable on state. This indicates that the drive circuit is in the normal link state. The fourth preset range is determined based on data from a plurality of experiments.

In some possible examples, a resistance value of each of the first resistor and the second resistor is greater than 1000 ohms.

It can be learned that, because the resistance value of each of the first resistor and the second resistor is greater than 1000 ohms, the first resistor and the second resistor each have a high impedance characteristic. In this way, when both the first switch transistor and the second switch transistor are turned on, the first resistor and the first resistor each are equivalent to an open circuit in the drive circuit, so that the direct current power supply can supply the large current to the breaking switch circuit.

In some possible examples, the drive circuit further includes a third resistor, and the first terminal of the first switch transistor is connected to the second terminal of the second switch transistor through the third resistor. In this way, when both the first switch transistor and the second switch transistor are turned on, and the two terminals of the drive port of the breaking switch circuit are short-circuited, the third resistor can protect the direct current power supply.

In some possible examples, a resistance value of the third resistor is greater than 1 ohm and less than 10 ohms.

It can be learned that, because the resistance value of the third resistor is greater than 1 ohm and less than 10 ohm, the third resistor has a low impedance characteristic. In this way, when both the first switch transistor and the second switch transistor are turned on, because the first resistor and the second resistor each have the high impedance characteristic, and the third resistor has the low impedance characteristic, a current supplied by the direct current power supply mainly flows to the breaking switch circuit through the third resistor. In addition, when the two terminals of the drive port of the breaking switch circuit are short-circuited, the third resistor can protect the direct current power supply. In some possible examples, the first switch transistor is an N-channel metal-oxide-semiconductor NMOS, and the second switch transistor is a P-channel metal-oxide-semiconductor PMOS. The first terminal of the first switch transistor is a drain of the NMOS, and the second terminal of the first switch transistor is a source of the NMOS. The first terminal of the second switch transistor is a source of the PMOS, and the second terminal of the second switch transistor is a drain of the PMOS.

In this way, when detecting that the fault current occurs on the circuit between the two power devices, the circuit breaking apparatus in this application controls both the NMOS and the PMOS to be turned on, to input the large current to the breaking switch circuit, to control the breaking switch circuit to cut off the circuit, so that the circuit breaking apparatus cuts off the fault current.

In some possible examples, the breaking switch circuit includes an electric igniter, an actuator, and a conductor. The electric igniter is connected between the first terminal of the drive port of the breaking switch circuit and the second terminal of the drive port of the breaking switch circuit. The breaking switch circuit is connected in series between the two power devices through the conductor. The electric igniter is configured to: when both the first switch transistor and the second switch transistor are turned on, push the actuator to break the conductor.

It can be learned that when it is detected that the current on the circuit between the two power devices connected in series to the breaking switch circuit is greater than the preset threshold, the controller may control both the first switch transistor and the second switch transistor to be turned on. In this case, the drive circuit supplies the large current to the electric igniter for specific time. In this way, the electric igniter pushes the actuator to break the conductor, to break the circuit between the two power devices.

According to a second aspect, this application provides a photovoltaic power generation system, including an inverter, a circuit breaking apparatus, and a transformer. The circuit breaking apparatus includes a breaking switch circuit and a drive circuit. The breaking switch circuit is connected in series between the inverter and the transformer. The drive circuit includes a direct current power supply, a first switch transistor, a second switch transistor, a first resistor, a second resistor, and a controller. A first terminal of the first switch transistor is connected to a positive electrode of the direct current power supply through the first resistor, a second terminal of the first switch transistor is connected to a first terminal of a drive port of the breaking switch circuit, and a second terminal of the drive port of the breaking switch circuit is connected to a negative electrode of the direct current power supply. A first terminal of the second switch transistor is connected to the positive electrode of the direct current power supply, and a second terminal of the second switch transistor is connected to the negative electrode of the direct current power supply through the second resistor. The first terminal of the first switch transistor is connected to the second terminal of the second switch transistor. The controller is configured to: when a current on the circuit between the inverter and the transformer is greater than a preset threshold, control both the first switch transistor and the second switch transistor to be turned on. The breaking switch circuit is configured to break the circuit between the inverter and the transformer when both the first switch transistor and the second switch transistor are turned on.

It can be learned that when the current on the circuit between the inverter and the transformer in the photovoltaic power generation system is greater than the preset threshold, it indicates that a fault current occurs on the circuit in the photovoltaic power generation system. To prevent fault spreading and ensure that the circuit in the photovoltaic power generation system is not damaged, when the circuit breaking apparatus in this application detects that the fault current occurs on the circuit in the photovoltaic power generation system, the controller controls both the two switch transistors in the drive circuit to be turned on. In this case, the direct current power supply inputs a large current to the breaking switch circuit to control the breaking switch circuit to cut off the circuit in the photovoltaic power generation system, so that the circuit breaking apparatus cuts off the fault current, to ensure security of the photovoltaic power generation system.

In addition, because the circuit breaking apparatus is a "suicide" protection circuit, the circuit breaking apparatus needs to avoid mistakenly triggering generation of the large current, and needs to ensure a trusted action of the drive circuit. In this case, the drive circuit uses a design of the two switch transistors, and the direct current power supply inputs the large current to the breaking switch circuit only when both the two switch transistors are turned on, and the large current cannot be supplied to the breaking switch circuit when either of the switch transistors is turned on. This helps avoid mistakenly triggering generation of the large current, and can ensure the trusted action of the drive circuit.

In some possible examples, the controller is further configured to: when the first switch transistor is turned off, the second switch transistor is turned off, and a voltage between two terminals of the second resistor falls within a first preset range, output a signal indicating that the drive circuit is in a normal link state.

In some possible examples, the controller is further configured to: when the first switch transistor is turned on, the second switch transistor is turned off, a voltage between the two terminals of the drive port of the breaking switch circuit falls within a second preset range, and a voltage between two terminals of the second resistor falls within a third preset range, output a signal indicating that the drive circuit is in a normal link state.

In some possible examples, the controller is further configured to: when the first switch transistor is turned off, the second switch transistor is turned on, and a voltage between two terminals of the second resistor falls within a fourth preset range, output a signal indicating that the drive circuit is in a normal link state.

In some possible examples, a resistance value of each of the first resistor and the second resistor is greater than 1000 ohms.

In some possible examples, the drive circuit further includes a third resistor, and the first terminal of the first switch transistor is connected to the second terminal of the second switch transistor through the third resistor.

In some possible examples, a resistance value of the third resistor is greater than 1 ohm and less than 10 ohms.

In some possible examples, the first switch transistor is an NMOS, and the second switch transistor is a PMOS. The first terminal of the first switch transistor is a drain of the NMOS, and the second terminal of the first switch transistor is a source of the NMOS. The first terminal of the second switch transistor is a source of the PMOS, and the second terminal of the second switch transistor is a drain of the PMOS.

In some possible examples, the breaking switch circuit includes an electric igniter, an actuator, and a conductor. The electric igniter is connected between the first terminal of the drive port of the breaking switch circuit and the second terminal of the drive port of the breaking switch circuit. The breaking switch circuit is connected in series between the inverter and the transformer through the conductor. The electric igniter is configured to: when both the first switch transistor and the second switch transistor are turned on, push the actuator to break the conductor.

### BRIEF DESCRIPTION OF DRAWINGS

FIG. 1 to FIG. 3 each are a diagram of an architecture of a photovoltaic energy storage system according to an embodiment of this application; and
FIG. 4 to FIG. 10 each are a diagram of a structure of a circuit breaking apparatus according to an embodiment of this application.

### DESCRIPTION OF EMBODIMENTS

To make a person skilled in the art understand technical solutions in this application better, the following clearly and completely describes the technical solutions in this application with reference to the accompanying drawings in this application. It is clear that the described embodiments are merely some rather than all of embodiments of this application. All other embodiments obtained by a person skilled in the art based on descriptions of embodiments of this application without creative efforts shall fall within the protection scope of this application.

It should be understood that the terms "first" and "second" in this application are intended to distinguish between different objects but do not indicate a specific sequence. In addition, the terms "include" and "have" and any other variants thereof are intended to cover a non-exclusive inclusion. For example, a process, a method, software, a product, or a device that includes a series of steps or units is not limited to the listed steps or units, but further includes unlisted steps or units, or further includes other inherent steps or units of the process, the method, the product, or the device.

An "embodiment" in this application means that a particular characteristic, structure, or feature described with reference to the embodiment may be included in at least one embodiment of this application. The phrase shown in various locations in the specification may neither necessarily mean a same embodiment, nor mean an independent or optional embodiment exclusive from another embodiment. In addition, embodiments described in this specification may be combined with other embodiments.

The term "and/or" in embodiments of this application may describe an association relationship between associated objects, and there may be three relationships. For example, A and/or B may indicate the following three cases: "A", "B", and "A and B". A and B may be singular or plural.

The symbol "/" in embodiments of this application may indicate an "or" relationship between the associated objects. In addition, the symbol "/" may also indicate a division sign, that is, perform a division operation. For example, A/B may indicate that A is divided by B.

In embodiments of this application, "at least one item (piece) "or a similar expression thereof means any combination of these items, including a single item (piece) or any combination of plural items (pieces), and means one or more. "A plurality of" means two or more. For example, at least one of a, b, or c may indicate the following seven cases: "a", "b", "c", "a and b", "a and c", "b and c", and "a, b, and c". Each of a, b, and c may be an element, or may be a set that includes one or more elements.

"Coupling" and "connection" in embodiments of this application may indicate an electrical connection, and may include a direct connection through a wire or a connection end or an indirect connection through another device (for example, an inductor, a capacitor, or a resistor). Therefore, "coupling" and "connection" may be considered as a generalized electronic communication connection. In addition, the displayed or discussed mutual couplings/direct couplings/communication connections may be indirect couplings or communication connections through some interfaces, apparatuses, units, or devices, and may be implemented in communication, electronic, or other forms.

Circuits or other components in embodiments of this application may be described as "being configured to" perform one or more tasks. In this case, "being configured to" may be used for implying a structure by indicating that a circuit/component includes a structure (for example, a circuit system) that performs one or more tasks during an operation. Therefore, even when a specified circuit/component is currently not operable, the circuit/component may also be referred to as being configured to perform the task. The circuit/component used in conjunction with the phrase "being configured to" includes hardware, for example, a circuit for performing an operation.

A photovoltaic energy storage system may include two parts: a photovoltaic power generation system and an energy storage system. The photovoltaic energy storage system is a system using solar photovoltaic power generation and energy storage technologies, to convert solar energy into electric energy that can be used by a power grid or a load.

The photovoltaic power generation system is a system using solar photovoltaic power generation, and may include a photovoltaic panel, an inverter, a transformer, a power grid connection apparatus, and the like. The photovoltaic panel converts solar energy into direct current electric energy through a photovoltaic effect. The inverter may convert a direct current into an alternating current, to meet a requirement of power grid access or load power supply. The transformer may perform step-up or step-down. The power grid connection apparatus is configured to connect the photovoltaic power generation system to the power grid, to implement mutual transmission of electric energy.

The energy storage system is a system using an energy storage technology, may be configured to store redundant electric energy, and may include an energy storage unit, a converter, a transformer, and the like. The energy storage system may charge or discharge a battery by using the converter. The energy storage unit may include a battery component. A common battery component may include a lithium-ion battery, a sodium sulfur battery, a flow battery, or the like. The energy storage system further includes a battery management system, configured to monitor and control a charging and discharging process of the battery, to prolong a battery life and improve system efficiency.

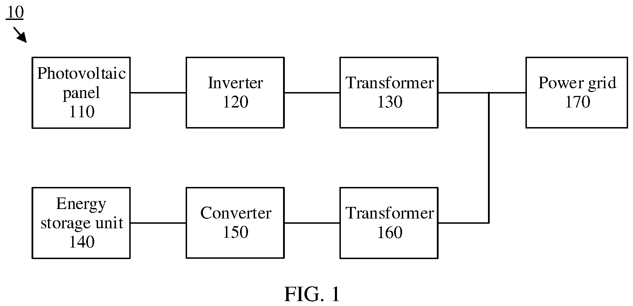

For example, as shown in FIG. 1, a photovoltaic energy storage system 10 includes a photovoltaic panel 110, an inverter 120, a transformer 130, an energy storage unit 140, a converter 150, a transformer 160, and a power grid 170. In the photovoltaic energy storage system 10, the photovoltaic panel 110 mainly converts solar energy into a direct current, then the inverter 120 converts the direct current into an alternating current, and finally the transformer 130 adjusts a voltage and a current, to provide an adjusted voltage and current for the power grid 170. Redundant electric energy stored in the energy storage unit 140 is inverted by the converter 150 into an alternating current, then a voltage and a current are adjusted by the transformer 130, and an adjusted voltage and current are provided for the power grid 170.

Certainly, FIG. 1 is merely an example of a network architecture of the photovoltaic energy storage system, and does not constitute a limitation on the architecture of the photovoltaic energy storage system in embodiments of this application.

It is of great significance to ensure security in the photovoltaic energy storage system. A power switch device in the converter/inverter is a circuit that is prone to a fault (for example, a short circuit). When the power switch device is faulty, a short-circuit path for short-circuiting the battery may be formed. As a result, a power component on a photovoltaic side or an energy storage side is damaged, and a fault of the photovoltaic energy storage system is spread, reducing security of the photovoltaic energy storage system.

To prevent fault spreading and ensure security of the photovoltaic energy storage system, a circuit breaking device with a fault current breaking function may be introduced. When detecting that a circuit is faulty, these circuit breaking devices can break the faulty circuit, quickly cut off a fault current, and separate a fault, to prevent the fault from spreading to another part.

A common circuit breaking device is a fuse. The fuse can quickly break the circuit when a fault like overload or a short circuit occurs on the circuit, to prevent a current from continuing to flow, thereby protecting the power switch device and another device. In addition to the fuse, another circuit breaking device may be used, for example, a circuit breaker (circuit breaker), a fast-acting switch (fast-acting switch), an electronic circuit breaker (electronic circuit breaker), a mechanical switch device, or an electronic switch device. However, the mechanical switch device cannot deal with a short-circuit current due to a slow action speed. Although the electronic switch device can cut off the short-circuit current quickly, the electronic switch device is connected in series in a main power loop, affecting system efficiency.

In view of this, to ensure security, a circuit breaking apparatus may be connected in series in the photovoltaic energy storage system in this embodiment. The circuit breaking apparatus is a switch device with a fault current breaking function. In this way, when detecting that a circuit is faulty, the circuit breaking apparatus can quickly cut off a fault current, to prevent fault spreading and protect a power switch device and another device from being damaged.

In the photovoltaic energy storage system, the circuit breaking apparatus in this embodiment may be connected to any location in a main power loop on a photovoltaic side or an energy storage side in the photovoltaic energy storage system. For example, in FIG. **1****,** a main power loop on a photovoltaic side is formed along the photovoltaic panel 110, the inverter 120, the transformer 130, and the power grid 170 in sequence; a main power loop on an energy storage side is formed along the energy storage unit 140, the converter 150, the transformer 160, and the power grid 170 in sequence; and a main power loop is formed along the photovoltaic panel 110, the inverter 120, the transformer 130, the transformer 160, the converter 150, and the energy storage unit 140 in sequence.

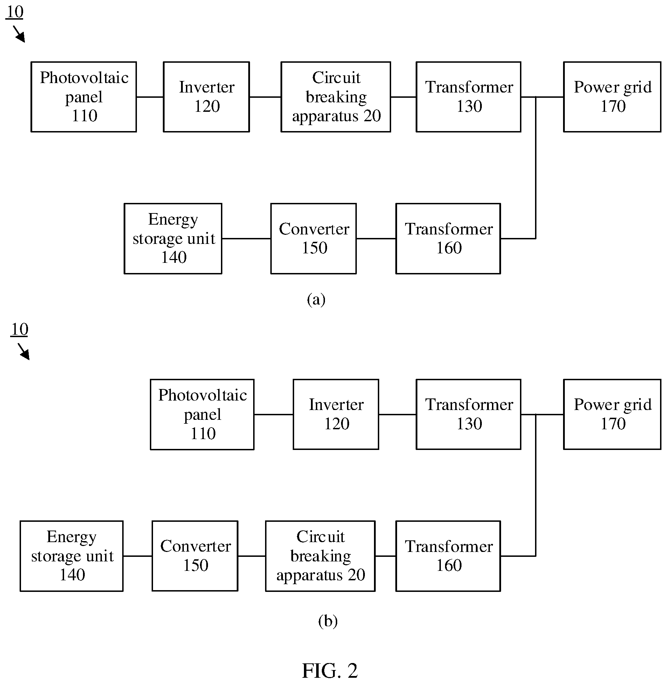

For example, the circuit breaking apparatus is connected to the main power loop on the photovoltaic side in the photovoltaic energy storage system 10. As shown in (a) in FIG. 2, the circuit breaking apparatus 20 is connected in series between the inverter 120 and the transformer 130. An alternating current output by the inverter 120 flows through the circuit breaking apparatus 20, and then flows into the transformer 130 through the circuit breaking apparatus 20. When detecting that a circuit (for example, a power switch device in the inverter 120) in the photovoltaic energy storage system 10 is faulty, the circuit breaking apparatus 20 can quickly cut off a fault current in the photovoltaic energy storage system 10, to prevent fault spreading and protect another circuit in the photovoltaic energy storage system 10 from being damaged.

For example, the circuit breaking apparatus is connected to the main power loop on the energy storage side in the photovoltaic energy storage system 10. As shown in (b) in FIG. 2, the circuit breaking apparatus 20 is connected in series between the converter 150 and the transformer 160. An alternating current output by the converter 150 flows through the circuit breaking apparatus 20, and then flows into the transformer 160 through the circuit breaking apparatus 20. When detecting that a circuit (for example, a power switch device in the converter 150) in the photovoltaic energy storage system 10 is faulty, the circuit breaking apparatus 20 can quickly cut off a fault current in the photovoltaic energy storage system 10, to prevent fault spreading and protect another circuit in the photovoltaic energy storage system 10 from being damaged.

In addition, the circuit breaking apparatus in this embodiment includes a breaking switch circuit and a drive circuit. The breaking switch circuit is connected in series between two power devices, and the drive circuit is connected to the breaking switch circuit.

It should be noted that an operation principle of the circuit breaking apparatus is described below.

When it is detected that a current on the circuit between the two power devices is greater than a preset threshold, it indicates that a fault current occurs on the circuit. In this case, the drive circuit inputs a large current to the breaking switch circuit, and the breaking switch circuit breaks the circuit under the large current, to cut off the fault current. This prevents fault spreading, and ensures that the circuit is not damaged.

In addition, after the large current is supplied to the breaking switch circuit, because the breaking switch circuit breaks the circuit by damaging an interior component, the breaking switch circuit may be considered as a "suicide" protection circuit. In this way, in this embodiment, generation of the large current needs to be not mistakenly triggered while a trusted action of the drive circuit is ensured. Therefore, a design of the drive circuit is crucial.

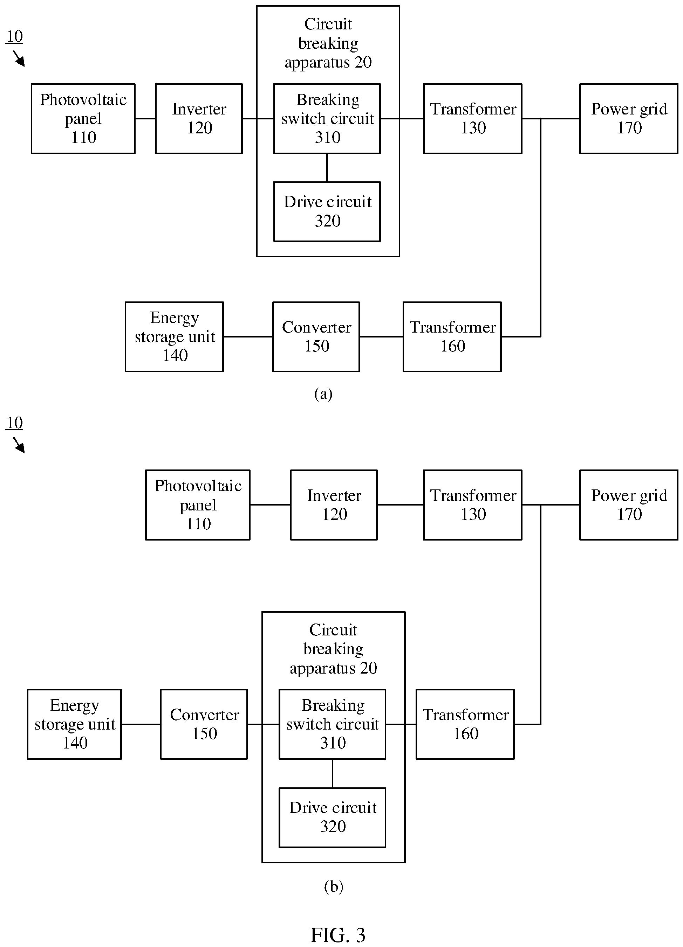

For example, based on (a) in FIG. 2, as shown in (a) in FIG. 3, the circuit breaking apparatus 20 includes a breaking switch circuit 310 and a drive circuit 320. One end of the breaking switch circuit 310 is connected to an output end of the inverter 120, and the other end of the breaking switch circuit 310 is connected to an input end of the transformer 130. In other words, the breaking switch circuit 310 is connected in series between the inverter 120 and the transformer 130. The drive circuit 320 is connected to the breaking switch circuit 310. In this way, when it is detected that a current on the circuit between the inverter 120 and the transformer 130 is greater than a preset threshold, it indicates that a fault current occurs on the circuit. In this case, the drive circuit 320 inputs a large current to the breaking switch circuit 310, and the breaking switch circuit 310 breaks the circuit under the large current, to cut off the fault current. This prevents fault spreading, ensures that the circuit is not damaged, and ensures security of the photovoltaic energy storage system.

Based on (b) in FIG. 2, as shown in (b) in FIG. 3, the circuit breaking apparatus 20 includes a breaking switch circuit 310 and a drive circuit 320. One end of the breaking switch circuit 310 is connected to an output end of the converter 150, and the other end of the breaking switch circuit 310 is connected to an input end of the transformer 160. **In** other words, the breaking switch circuit 310 is connected in series between the converter 150 and the transformer 160. The drive circuit 320 is connected to the breaking switch circuit 310. In this way, when it is detected that a current on the circuit between the converter 150 and the transformer 160 is greater than a preset threshold, it indicates that a fault current occurs on the circuit. In this case, the drive circuit 320 inputs a large current to the breaking switch circuit 310, and the breaking switch circuit 310 breaks the circuit under the large current, to cut off the fault current. This prevents fault spreading, ensures that the circuit is not damaged, and ensures security of the photovoltaic energy storage system.

The following specifically describes circuit topology and an operation principle of the circuit breaking apparatus 20.

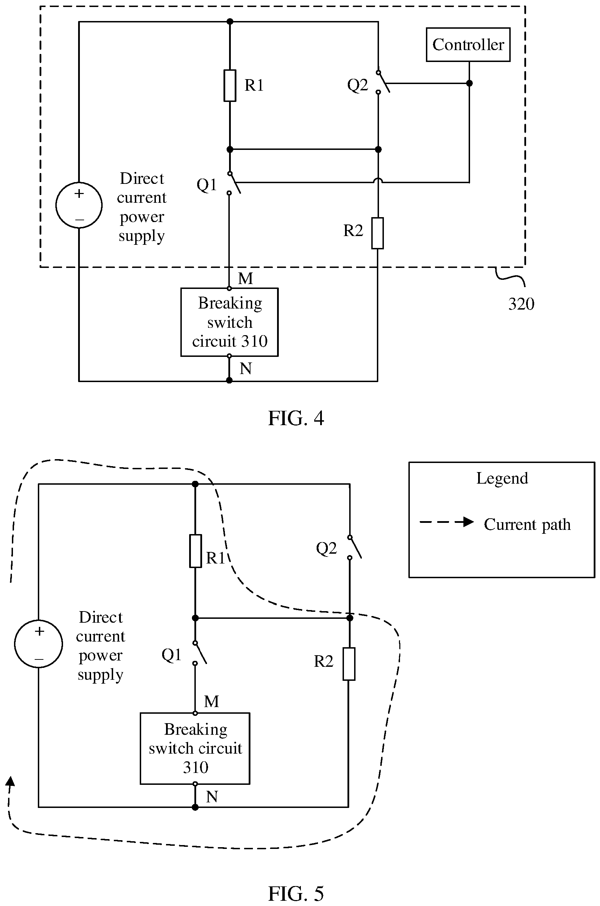

In a solution 1, FIG. 4 is a diagram of a structure of a circuit breaking apparatus according to an embodiment of this application. In FIG. 4, the circuit breaking apparatus 20 includes a breaking switch circuit 310 and a drive circuit 320. The drive circuit 320 includes a direct current (DC) power supply, a switch transistor Q1, a switch transistor Q2, a resistor R1, a resistor R2, and a controller.

A first terminal of the switch transistor Q1 is connected to a positive electrode of the direct current power supply through the resistor R1, a second terminal of the switch transistor Q1 is connected to a first terminal M of a drive port of the breaking switch circuit 310, and a second terminal N of the drive port of the breaking switch circuit is connected to a negative electrode of the direct current power supply. A first terminal of the switch transistor Q2 is connected to the positive electrode of the direct current power supply, and a second terminal of the switch transistor Q2 is connected to the negative electrode of the direct current power supply through the resistor R2. The first terminal of the switch transistor Q1 is connected to the second terminal of the switch transistor Q2.

The controller may be configured to separately control the switch transistor Q1 and the switch transistor Q2 to be turned on or off.

It should be noted that the resistor R1 and the resistor R2 each have a high impedance characteristic. This indicates that the resistor R1 and the resistor R2 each have a high resistance value. In this case, the resistor R1 and the resistor R2 are equivalent to an open circuit in the drive circuit.

Specifically, a resistance value of each of the resistor R1 and the resistor R2 is at a kilo-ohm level. In this way, the resistor R1 and the resistor R2 each have the high impedance characteristic. For example, a resistance value of each of the resistor R1 and the resistor R2 is greater than 1000 ohms.

In addition, the switch transistor Q1 and the switch transistor Q2 each may be a triode, a metal-oxide-semiconductor field-effect transistor (metal-oxide-semiconductor field-effect transistor, MOSFET), an insulated gate bipolar transistor (insulated gate bipolar transistor, IGBT), or the like. This is not specifically limited.

For example, the switch transistor Q1 and the switch transistor Q2 are MOSFETs. The switch transistor Q1 may be an N-channel metal-oxide-semiconductor (N-channel Metal-Oxide-Semiconductor, NMOS) transistor, and the switch transistor Q2 may be a P-channel metal-oxide-semiconductor (P-channel Metal-Oxide-Semiconductor, PMOS) transistor. A drive terminal of the switch transistor Q1 is a gate of the NMOS transistor, the first terminal of the switch transistor Q1 is a drain of the NMOS transistor, and the second terminal of the switch transistor Q1 is a source of the NMOS transistor. A drive terminal of the switch transistor Q2 is a gate of the PMOS transistor, the first terminal of the switch transistor Q2 is a source of the PMOS transistor, and the second terminal of the switch transistor Q2 is a drain of the PMOS transistor.

The following describes an operation principle of the circuit breaking apparatus 20 and link security self-check.

When both the switch transistor Q1 and the switch transistor Q2 are turned off, there is a circuit loop in the circuit breaking apparatus 20, and the drive circuit 320 does not supply a current to the breaking switch circuit 310, as shown in FIG. 5.

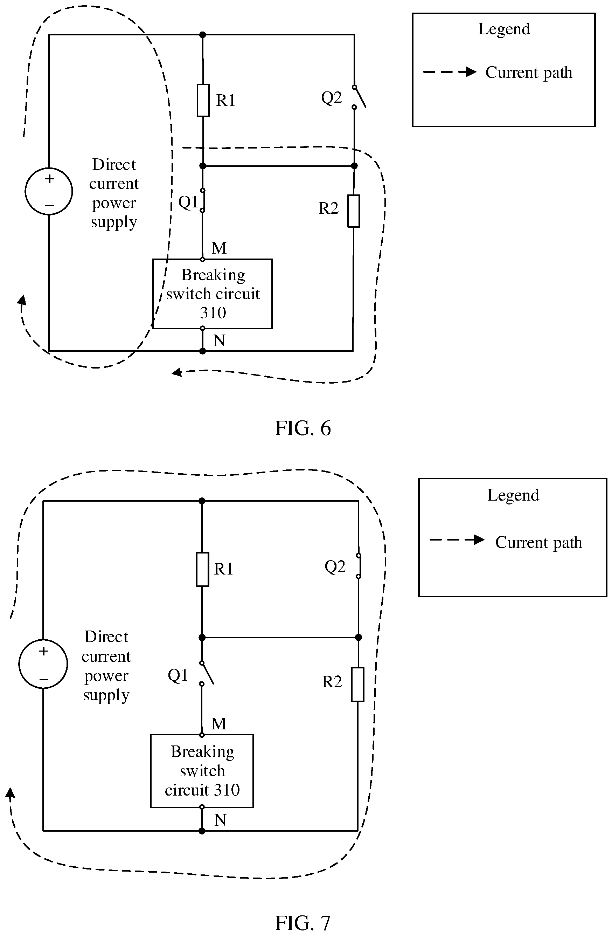

When the switch transistor Q1 is turned on and the switch transistor Q2 is turned off, there is a circuit loop in the circuit breaking apparatus 20, as shown in FIG. 6. In FIG. 6, because the resistor R1 and the resistor R2 each have the high impedance characteristic, the drive circuit 320 supplies an extremely small current to the breaking switch circuit 310.

When the switch transistor Q1 is turned off and the switch transistor Q2 is turned on, there is a circuit loop in the circuit breaking apparatus 20, as shown in FIG. 7. In FIG. 7, because the resistor R2 has the high impedance characteristic, which is equivalent to an open circuit, a current mainly flows through the switch transistor Q2 and the resistor R2, and the drive circuit 320 does not supply a current to the breaking switch circuit 310.

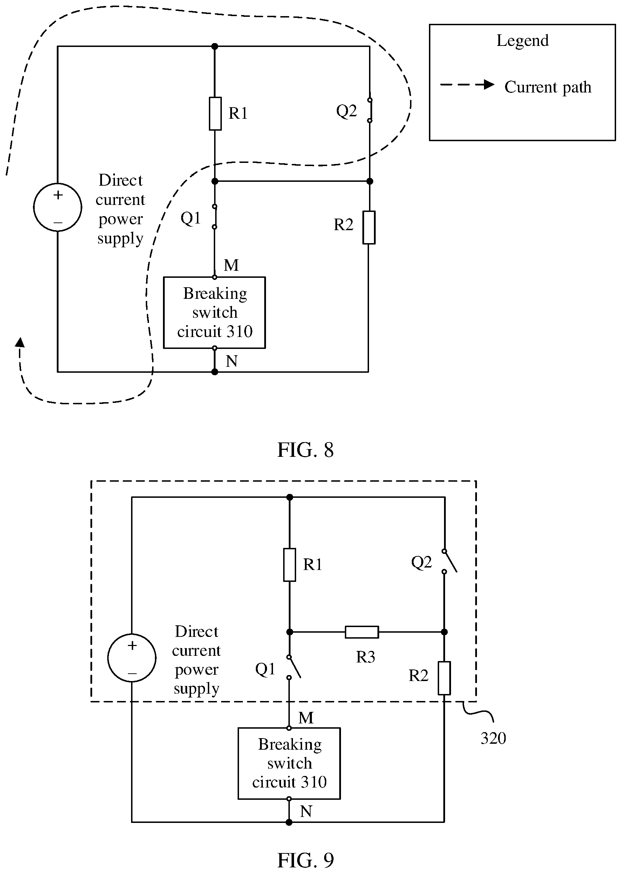

When both the switch transistor Q1 and the switch transistor Q2 are turned on, there is a circuit loop in the circuit breaking apparatus 20, as shown in FIG. 8. In FIG. 8, because the resistor R1 and the resistor R2 each have the high impedance characteristic, which is equivalent to an open circuit, a current mainly flows through the switch transistor Q2, the switch transistor Q1, and the breaking switch circuit 310, and the drive circuit 320 supplies a large current to the breaking switch circuit 310.

In conclusion, the operation principle of the circuit breaking apparatus 20 is described below.

In a normal operation condition of the circuit breaking apparatus 20, both the switch transistor Q1 and the switch transistor Q2 are in an off state. When it is detected that a current on the circuit between two power devices connected in series to the breaking switch circuit 310 is greater than a preset threshold, the controller may output a drive signal used to drive both the switch transistor Q1 and the switch transistor Q2 to be turned on. In this case, the direct current power supply in the drive circuit 320 inputs a large current to the breaking switch circuit 310, and the breaking switch circuit breaks the circuit between the two power devices under the large current.

In this way, the circuit breaking apparatus 20 cuts off a fault current, to prevent fault spreading, ensure that an exterior circuit is not damaged, and ensure security of the photovoltaic energy storage system.

Because the circuit breaking apparatus 20 is a "suicide" protection circuit, the circuit breaking apparatus 20 needs to avoid mistakenly triggering generation of the large current, and needs to ensure a trusted action of the drive circuit. Based on the foregoing two points, in the drive circuit 320 shown in FIG. 4 uses a design of two switch transistors. In addition, the large current is input to the breaking switch circuit 310 only when both the two switch transistors are turned on, and the large current cannot be supplied when either of the switch transistors is turned on. This helps avoid mistakenly triggering generation of the large current, and can ensure the trusted action of the drive circuit.

In addition, before the converter/inverter or the like in the photovoltaic energy storage system is started/operates normally, in this embodiment, link security self-check needs to be first performed on components, including the breaking switch circuit 310 and the drive circuit 320, of the circuit breaking apparatus 20. Link security self-check logic of the circuit breaking apparatus 20 is described below.
(1) When both the switch transistor Q1 and the switch transistor Q2 are turned off, a voltage between two terminals of the resistor R2 is detected. In this case, the circuit loop in the circuit breaking apparatus 20 is shown in FIG. 5. When the voltage between the two terminals of the resistor R2 falls within a first preset range, it indicates that a link "Resistor R1->Resistor R2" is normal. That is, the link in the circuit loop shown in FIG. 5 is normal, and both the switch transistor Q1 and the switch transistor Q2 are in a reliable off state and are not faulty. This indicates that the drive circuit 320 is in a normal link state. The first preset range is determined based on data from a plurality of experiments.
(2) When the switch transistor Q1 is turned on and the switch transistor Q2 is turned off, a voltage between two terminals of a drive port (that is, a voltage between an M port and an N port) of the breaking switch circuit 310 and a voltage between two terminals of the resistor R2 are detected. In this case, the circuit loop in the circuit breaking apparatus 20 is shown in FIG. 6. When the voltage between the two terminals of the drive port of the breaking switch circuit 310 falls within a second preset range, and the voltage between the two terminals of the resistor R2 falls within a third preset range, it indicates that a link "Resistor R1->Switch transistor Q1->Breaking switch circuit 310" is normal, and a link "Resistor R1->Resistor R2" is normal. That is, the links in the circuit loop shown in FIG. 6 are normal, the switch transistor Q1 is in a reliable on state, and the switch transistor Q2 is in a reliable off state. This indicates that the drive circuit 320 is in a normal link state. The second preset range and the third preset range are determined based on data from a plurality of experiments.
(3) When the switch transistor Q1 is turned off and the switch transistor Q2 is turned on, a voltage between two terminals of the resistor R2 is detected. In this case, the circuit loop in the circuit breaking apparatus 20 is shown in FIG. 7. When the voltage between the two terminals of the resistor R2 falls within a fourth preset range, it indicates that a link "Switch transistor Q2>Resistor R2" is normal. That is, the link in the circuit loop shown in FIG. 7 is normal, the switch transistor Q1 is in a reliable off state, and the switch transistor Q2 is in a reliable on state. This indicates that the drive circuit 320 is in a normal link state. The fourth preset range is determined based on data from a plurality of experiments.

The foregoing security self-check is completed. If a link of the drive circuit 320 is normal, the converter/inverter may operate normally.

The following specifically describes a solution 2.

For the circuit breaking apparatus 20 in the solution 1, in the solution 2, a resistor with a low impedance characteristic is added to a link between a first terminal of the switch transistor Q1 and a second terminal of the switch transistor Q2, so that when both the switch transistor Q1 and the switch transistor Q2 are turned on, because the resistor R1 and the resistor R2 each have the high impedance characteristic, and a resistor R3 has the low impedance characteristic, a current provided by the direct current power supply mainly flows to the breaking switch circuit 310 through the resistor R3. In addition, when two terminals of a drive port of the breaking switch circuit 310 are short-circuited, the resistor R3 can protect the direct current power supply in the drive circuit 320.

Based on FIG. 4, FIG. 9 is a diagram of a structure of another circuit breaking apparatus according to an embodiment of this application. In FIG. 9, the drive circuit 320 further includes the resistor R3. The first terminal of the switch transistor Q1 is connected to the second terminal of the switch transistor Q2 through the resistor R3. The resistor R3 has a low impedance characteristic. In this way, when both the switch transistor Q1 and the switch transistor Q2 are turned on, the resistor R3 can protect the direct current power supply when the two terminals of the drive port of the breaking switch circuit 310 are short-circuited.

Specifically, a resistance value of the resistor R3 is at an ohm level. In this way, the resistor R3 has the low impedance characteristic. For example, a resistance value of the resistor R3 is greater than 1 ohm and less than 10 ohms.

It should be noted that, for an operation principle and link security self-check of the circuit breaking apparatus 20 shown in FIG. 9, refer to the foregoing content. Details are not described herein again.

The following specifically describes a solution 3.

For the circuit breaking apparatus 20 in the solution 1 or the solution 2, the breaking switch circuit 310 may have various types. A possible breaking switch circuit is provided in the solution 3.

For example, the breaking switch circuit 310 includes an electric igniter, an actuator, and a conductor. The electric igniter is connected between a first terminal M of a drive port of the breaking switch circuit 310 and a second terminal N of the drive port of the breaking switch circuit 310, and the breaking switch circuit 310 is connected in series between two power devices through the conductor.

It can be learned that an operation principle of the circuit breaking apparatus 20 is described below.

In a normal operation condition of the circuit breaking apparatus 20, both the switch transistor Q1 and the switch transistor Q2 are in an off state. When it is detected that a current on the circuit between two power devices connected in series to the breaking switch circuit 310 is greater than a preset threshold, the controller may control both the switch transistor Q1 and the switch transistor Q2 to be turned on. In this case, the direct current power supply in the drive circuit 320 supplies a large current to the electric igniter for specific time. In this way, the electric igniter pushes the actuator to break the conductor, to break the circuit between the two power devices. In addition, when both the switch transistor Q1 and the switch transistor Q2 are turned on, and the electric igniter is short-circuited, the resistor R3 can protect the direct current power supply.

Certainly, the breaking switch circuit may further include another component, for example, an arc-suppressing chamber.

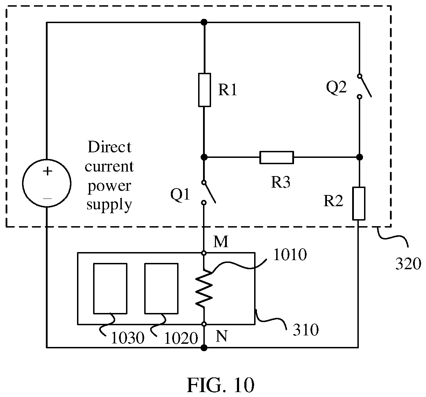

Based on FIG. 4, FIG. 10 is a diagram of a structure of still another circuit breaking apparatus according to an embodiment of this application. In FIG. 10, the breaking switch circuit 310 includes an electric igniter 1010, an actuator 1020, and a conductor 1030.

The electric igniter 1010 is connected between a first terminal M of a drive port of the breaking switch circuit 310 and a second terminal N of the drive port of the breaking switch circuit 310, and the breaking switch circuit 310 is connected in series between two power devices through the conductor 1030. The electric igniter 1010 is configured to: when both the switch transistor Q1 and the switch transistor Q2 are turned on, push the actuator 1020 to break the conductor 1030, to break the circuit between the two power devices.

In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

## Claims

1. A circuit breaking apparatus, comprising a breaking switch circuit and a drive circuit, wherein
the breaking switch circuit is connected in series between two power devices;
the drive circuit comprises a direct current power supply, a first switch transistor, a second switch transistor, a first resistor, a second resistor, and a controller;
a first terminal of the first switch transistor is connected to a positive electrode of the direct current power supply through the first resistor, a second terminal of the first switch transistor is connected to a first terminal of a drive port of the breaking switch circuit, and a second terminal of the drive port of the breaking switch circuit is connected to a negative electrode of the direct current power supply;
a first terminal of the second switch transistor is connected to the positive electrode of the direct current power supply, and a second terminal of the second switch transistor is connected to the negative electrode of the direct current power supply through the second resistor;
the first terminal of the first switch transistor is connected to the second terminal of the second switch transistor;
the controller is configured to: when a current on the circuit between the two power devices is greater than a preset threshold, control both the first switch transistor and the second switch transistor to be turned on; and
the breaking switch circuit is configured to break the circuit between the two power devices when both the first switch transistor and the second switch transistor are turned on.

2. The circuit breaking apparatus according to claim 1, wherein the controller is further configured to:
when the first switch transistor is turned off, the second switch transistor is turned off, and a voltage between two terminals of the second resistor falls within a first preset range, output a signal indicating that the drive circuit is in a normal link state.

3. The circuit breaking apparatus according to claim 1, wherein the controller is further configured to:
when the first switch transistor is turned on, the second switch transistor is turned off, a voltage between the two terminals of the drive port of the breaking switch circuit falls within a second preset range, and a voltage between two terminals of the second resistor falls within a third preset range, output a signal indicating that the drive circuit is in a normal link state.

4. The circuit breaking apparatus according to claim 1, wherein the controller is further configured to:
when the first switch transistor is turned off, the second switch transistor is turned on, and a voltage between two terminals of the second resistor falls within a fourth preset range, output a signal indicating that the drive circuit is in a normal link state.

5. The circuit breaking apparatus according to claim 1, wherein a resistance value of each of the first resistor and the second resistor is greater than 1000 ohms.

6. The circuit breaking apparatus according to claim 1, wherein the drive circuit further comprises a third resistor, and the first terminal of the first switch transistor is connected to the second terminal of the second switch transistor through the third resistor.

7. The circuit breaking apparatus according to claim 6, wherein a resistance value of the third resistor is greater than 1 ohm and less than 10 ohms.

8. The circuit breaking apparatus according to claim 1, wherein the first switch transistor is an N-channel metal-oxide-semiconductor NMOS, and the second switch transistor is a P-channel metal-oxide-semiconductor PMOS;
the first terminal of the first switch transistor is a drain of the NMOS, and the second terminal of the first switch transistor is a source of the NMOS; and
the first terminal of the second switch transistor is a source of the PMOS, and the second terminal of the second switch transistor is a drain of the PMOS.

9. The circuit breaking apparatus according to any one of claims 1 to 8, wherein the breaking switch circuit comprises an electric igniter, an actuator, and a conductor;
the electric igniter is connected between the first terminal of the drive port of the breaking switch circuit and the second terminal of the drive port of the breaking switch circuit;
the breaking switch circuit is connected in series between the two power devices through the conductor; and
the electric igniter is configured to: when both the first switch transistor and the second switch transistor are turned on, push the actuator to break the conductor.

10. A photovoltaic power generation system, comprising an inverter, a circuit breaking apparatus, and a transformer, wherein
the circuit breaking apparatus comprises a breaking switch circuit and a drive circuit;
the breaking switch circuit is connected in series between the inverter and the transformer;
the drive circuit comprises a direct current power supply, a first switch transistor, a second switch transistor, a first resistor, a second resistor, and a controller;
a first terminal of the first switch transistor is connected to a positive electrode of the direct current power supply through the first resistor, a second terminal of the first switch transistor is connected to a first terminal of a drive port of the breaking switch circuit, and a second terminal of the drive port of the breaking switch circuit is connected to a negative electrode of the direct current power supply;
a first terminal of the second switch transistor is connected to the positive electrode of the direct current power supply, and a second terminal of the second switch transistor is connected to the negative electrode of the direct current power supply through the second resistor;
the first terminal of the first switch transistor is connected to the second terminal of the second switch transistor;
the controller is configured to: when a current on the circuit between the inverter and the transformer is greater than a preset threshold, control both the first switch transistor and the second switch transistor to be turned on; and
the breaking switch circuit is configured to break the circuit between the inverter and the transformer when both the first switch transistor and the second switch transistor are turned on.

11. The photovoltaic power generation system according to claim 10, wherein the controller is further configured to:
when the first switch transistor is turned off, the second switch transistor is turned off, and a voltage between two terminals of the second resistor falls within a first preset range, output a signal indicating that the drive circuit is in a normal link state.

12. The photovoltaic power generation system according to claim 10, wherein the controller is further configured to:
when the first switch transistor is turned on, the second switch transistor is turned off, a voltage between the two terminals of the drive port of the breaking switch circuit falls within a second preset range, and a voltage between two terminals of the second resistor falls within a third preset range, output a signal indicating that the drive circuit is in a normal link state.

13. The photovoltaic power generation system according to claim 10, wherein the controller is further configured to:
when the first switch transistor is turned off, the second switch transistor is turned on, and a voltage between two terminals of the second resistor falls within a fourth preset range, output a signal indicating that the drive circuit is in a normal link state.

14. The photovoltaic power generation system according to claim 10, wherein a resistance value of each of the first resistor and the second resistor is greater than 1000 ohms.

15. The photovoltaic power generation system according to claim 10, wherein the drive circuit further comprises a third resistor, and the first terminal of the first switch transistor is connected to the second terminal of the second switch transistor through the third resistor.
